Europäisches Patentamt

European Patent Office

Office européen des brevets

(11) Publication number: **0 485 720 A2**

# EUROPEAN PATENT APPLICATION

(21) Application number: **91116150.3**

(22) Date of filing: **23.09.91**

(51) Int. Cl.⁵: **H01L 21/76**

(30) Priority: **16.11.90 JP 310722/90**

(43) Date of publication of application:
**20.05.92 Bulletin 92/21**

(84) Designated Contracting States:
**DE FR GB**

(71) Applicant: **SHIN-ETSU HANDOTAI COMPANY, LIMITED**
**4-2, Marunouchi 1-Chome**
**Chiyoda-ku Tokyo(JP)**

(72) Inventor: **Katayama, Masatake**
**179-7, Shimotoyooka-machi**
**Takasaki-shi, Gunma-ken(JP)**
Inventor: **Sato, Makoto**
**Cosmo Heights 205, 411-3, Hakoda-machi**
**Maebashi-shi, Gunma-ken(JP)**
Inventor: **Ohta, Yutaka**
**Gobara, Aprtment House A-10, 165-1, Gobara**
**Annaka-shi, Gunma-ken(JP)**
Inventor: **Sugita, Mitsuru, Ryokufu-Dormitory**
**150-5, Aza Ohhira, Ohaza Odakura,**
**Nishigo-mura**
**Nishishirakawa-gun, Fukushima-ken(JP)**
Inventor: **Ohki, Konomu**
**Shinpu-Dormitory, 1610, Nishikamiisobe**
**Annaka-shi, Gunma-ken(JP)**

(74) Representative: **Patentanwälte Grünecker,**
**Kinkeldey, Stockmair & Partner**
**Maximilianstrasse 58**
**W-8000 München 22(DE)**

(54) **Dielectrically isolated substrate and a process for producing the same.**

(57) A dielectrically isolated substrate is comprised of a single crystal silicon substrate or bond substrate and a single crystal silicon substrate or base substrate bonded together into a composite structure. The bond substrate has a (110) plane as a main crystal plane and is provided with vertically walled moats and substantially parallelogramatical islands positioned adjacent to the moats. The moats and islands result from anisotropic etching using a specific mask pattern. Also disclosed is a process for producing the composite structure.

F I G . 2

The present invention relates to substrates for use in integrated circuits and more particularly to a dielectrically isolated substrate of a bonding type having parallelogramatical islands of a maximized area. The invention further relates to a process for producing such a unique substrate.

In fabricating those substrates intended for use in integrated circuits for semiconductor devices, a p-n junction isolation technique using diffusion layers has been widely employed to isolate the individual elements of the substrate from each other. This isolation diffusion technique is not only relatively simple in steps but easy in process control. However, it is susceptible to excessive isolation capacitances and poor high frequency characteristics and hence low operating speed in circuits. Alternatively, a dielectric isolation technique using dielectric layers has been proposed which is reputed as fully acceptable in parasitic capacitances and breakdown characteristics.

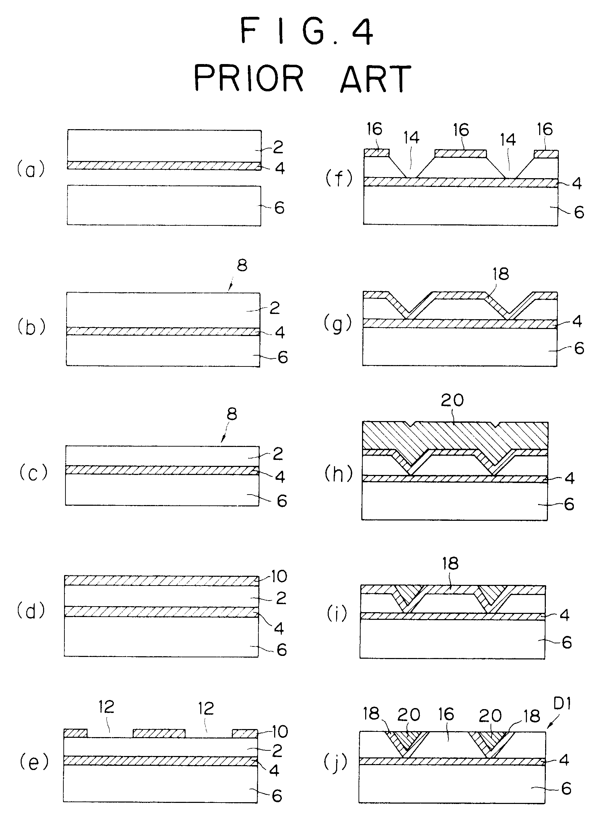

A dielectrically isolated substrate of a bonding type is known to be a substrate obtained by the last-mentioned dielectric isolation technique as disclosed for instance in Japanese Patent Laid-Open Publication No. 62-229855. This conventional substrate is produced as will be hereunder described with reference to FIGS. 4(a) through 4(j).

An $N^+$ dopant such as of antimony (Sb), arsenic (Ar) or the like is buried and diffused to a mirror polished surface of a single crystal silicon substrate or bond substrate 2 with a (100) plane as the main crystl plane as shown in FIG. 4(a), followed by formation of a dielectric film 4 of silicon dioxide ($SiO_2$) over the surface of the bond substrate 2 as by thermal oxidation. The bond substrate 2 is contacted with another substrate or base substrate 6 with their mirror polished surface opposed to each other and thereafter bonded together into an integral structure 8 at above 200°C as depicted in FIG. 4(b).

The substrate 2 of the structure 8 is ground and polished to a thickness of 30 to 50 $\mu$m [FIG. 4-(c)], followed by formation of oxide film 10 of nearly 0.6 $\mu$m in thickness, for subsequent photo-lithography, over an outer surface of the substrate 2 as through thermal oxidation [FIG. 4(d)]. Small openings or windows 12 are formed photo-lithographically selectively in the oxide film 10 according to an isolation mask pattern [FIG. 4(e)], whereby the surface of the substrate 2 is anisotropically etched through the windows 12 into V-shaped isolation grooves or moats 14 so that island regions 16 are formed on both sides of each of the moats 14 [FIG. 4(f)]. An isolation oxide film 18 is then disposed in a thickness of about 2 $\mu$m and over both the islands and the moats [FIG. 4(g)]. Deposited over the oxide film 18 is a polycrystalline silicon layer 20 in a thickness of 40 to 80 $\mu$m [FIG.

4(h)], whereupon lapping is effected from toward the silicon layer 20 with the oxide film 18 being used as a stopper layer [FIG. 4(i)]. A dielectrically isolated substrate D1 is obtained by finally removing the oxide film 18 [FIGS. 4(j) and 5].

The above substrate of the prior art derivable from a single crystal silicon substrate with a (100) plane as the main crystal plane, is disadvantageous in that it is necessarily narrow in island area due to the corresponding V-shaped isolation moats. The island area becomes smaller as the substrate increases in thickness.

With the foregoing drawbacks of the prior art in view, the present invention seeks to provide a dielectrically isolated substrate for use in integrated circuits which exhibits increased integration with maximized island area, parallelogramatical island surface and minimized surface loss. The invention also seeks to provide a process for the production of such a substrate.

Many other objects and advantages of the invention will be apparent from the following description with reference to the accompanying drawings.

In one aspect the invention provides a dielectrically isolated substrate for use in integrated circuits, which comprises a single crystal silicon bond substrate and a single crystal silicon base substrate integrally bonded to the bond substrate, the bond substrate including a plurality of discrete, vertical moats and a plurality of parallelogramatical islands each positioned contiguous to each of the moats.

In another aspect the invention provides a dielectrically isolated substrate for use in integrated circuits, which comprises a single crystal silicon bond substrate having a (110) plane as a main crystal plane, and a single crystal silicon base substrate integrally bonded to the bond substrate, the bond substrate including a plurality of discrete, vertical moats and a plurality of parallelogramatical islands each positioned contiguous to each of the moats, each of the moats being formed by the use of a mask pattern of a parallelogramatical shape.

In still another aspect, the invention provides a process for producing a dielectrically isolated substrate for use in integrated circuits, which comprises the steps of: (a) coating a single crystal silicon bond substrate with a dielectric film, bringing the bond substrate into intimate contact with a single crystal silicon base substrate and heat-treating the same into a composite structure; (b) polishing the composite structure on a front surface of the bond substrate to a thickness; (c) forming an oxide film for photo-lithograpy over the polished surface of the bond substrate; (d) photo-lithographing the oxide film selectively with use of a mask pattern to thereby open a plurality of windows; (e) etching the bond substrate through the windows to thereby form a plurality of moats terminating at the dielectric film and a plurality of islands each positioned contiguous to each of the moats; (f) coating a dielectric isolation film onto the bond substrate; (g) depositing a polycrystalline silicon layer in a thickness onto the dielectric isolation film; (h) lapping the polycrystalline silicon layer until the surface of each of the islands is exposed; and (i) subsequently removing the dielectric isolation film, wherein the bond substrate has a (110) plane as a main crystal plane and is subjected to anisotropic etching under alkaline conditions whereby each of the moats has substantially vertical walls ending at the dielectric film, and each of the islands has a parallelogramatical shape.

FIGS. 1(a) to 1(j) are diagrammatical cross-sectional views illustrative of the sequence of the process of fabricating a dielectrically isolated substrate according to the present invention;

FIG. 2 is a view, enlarged segmentally and seen cross-sectionally, of the dielectrically isolated substrate provided in accordance with the invention;

FIG. 3 is a plan view showing one form of the mask patern according to the invention;

FIGS. 4(a) to 4(j) are cross-sectional views explanatory of the prior art method in sequence; and

FIG. 5 is an enlarged cross-sectional view of the dielectrically isolated substrate according to the prior art method.

The process according to the present invention is comprised of several specific process steps described later.

A bond substrate formed from a signal crystal silicon and coated with a dielectric film is brought into contact with a base substrate from a single crystal silicon, and both substrates are heat-treated together into an integrally bonded structure. The resulting composite structure is polished on one surface to a thickness. Over the polished surface of the structure is coated an oxide film for being subsequently photo-lithographed. The oxide film is selectively removed by photo-lithography so as to match a given mask pattern, thereby defining small openings or windows. The bond substrate on its outer surface is etched through the windows, thus forming moats terminating at the above dielectric film and hence island regions standing in contiguous relation to the moats. The outer surface of the bond substrate thus etched is coated with a dielectric isolation film on which a polycrystalline silicon layer is deposited to a thickness. The silicon layer is lapped uniformly until the surface of each of the islands is exposed. The dielectric isolation film is finally removed.

One important feature of the process of the invention resides in using a single crystal silicon of a (110) plane as the main crystal plane for the bond substrate and also in anisotropically etching the bond substrate with an alkaline etchant. This specific etching contributes to formation of discrete, vertical moats extending along the windows up to the dielectric film, giving rise to parallelogramatical islands.

To prevent the islands against corner erosion and to maximize the island area, a mask pattern is positioned on the bond substrate, the mask pattern being parallelogramatical with two pairs of two opposed sides. One pair of sides extend vertically to one group of the ⟨111⟩ orientation of the bond substrate, and another pair of sides are vertical to another group of the ⟨111⟩ orientation. Disposed on the mask pattern at its corners are compensating patterns to render the resulting island fully parallelogramatical after anisotropic etching to a depth and eventually great in area.

The process of the invention is designed to utilize the inherent characteristics of anisotropic etching, namely slower etching on the {111} planes than on the {110} planes. The geometrical shapes particularly of the vertical moats and parallelogramatical islands are attributed to the use of the above mask pattern of a parallelogramatical form having two different angles of 70.5° and 109.5° on the (110) plane. Etching is done in the presence of an alkaline etchant such as for example aqueous potassium hydroxide (KOH).

At an opening of the mask pattern, the etch rate on the {111} planes is extremely low as against that on the {110} planes so that etching develops rapidly vertically or in the ⟨110⟩ orientation but hardly laterally or in the ⟨111⟩ orientation. Thus, on the bond substrate is formed a moat having walls of the (111) plane upstanding vertically with respect to the surface of the base substrate and corresponding substantially to the width of the mask pattern opening. There is thus obtained a parallelogramatical island surrounded by a plurality of moats.

On exposure to anisotropic etching, a parallelogramatical island of the above character tends to undergo speedy etch at its corners, resulting in corner erosion. To solve this problem, the invention involves the use of compensating patterns located at the corners of the mask pattern, thereby forming a fully parallelogramatical island after etching. This specific arrangement enables the recesses to be smaller in width and thus the resultant islands to be larger in area, leading to great effective area and hence high integration of the junction substrate.

The following examples are given to further explain the invention. These examples should be regarded as illustrative but not as restrictive.

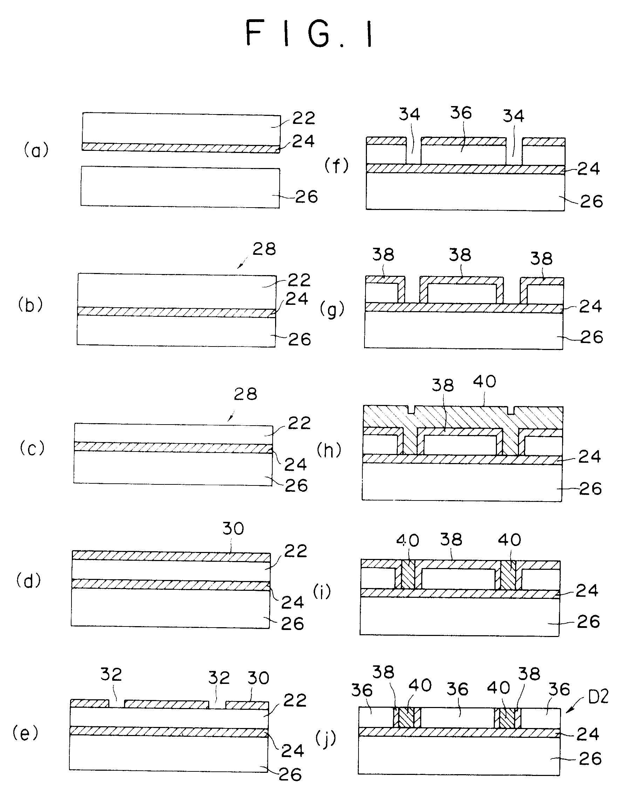

With reference to the drawings and FIGS. 1(a) to 1(j) in particular, an N$^+$ dopant such as of antimony (Sb), arsenic (Ar) or the like is buried and diffused to a mirror polished surfaceof a single crystal silicon substrate or bond substrate 22 of a (110) plane as the main crystl plane as shown in FIG. 1(a), followed by formation of a dielectric film 24 of silicon dioxide (SiO$_2$) over that surface of the bond substrate 22 as by thermal oxidation.

Importantly, the single crystal silicon bond substrate 22 has a (110) crystal plane in place of the prior art substrate of a (100) plane.

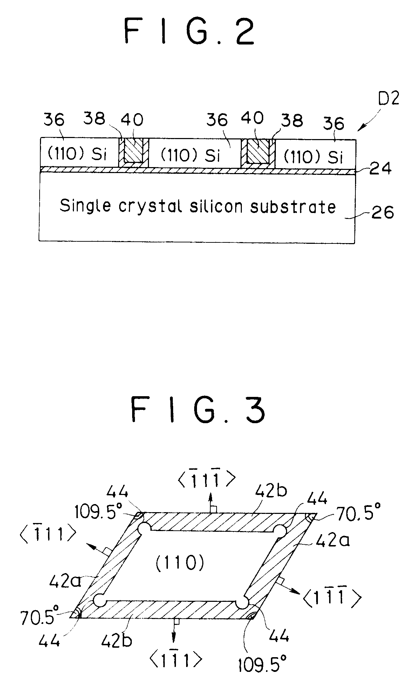

The bond substrate 22 is contacted with another substrate or base substrate 26 with their mirror polished surface opposed to each other and thereafter bonded together into an integral structure 28 at above 200°C as depicted in FIG. 1(b). The substrate 22 of the structure 28 is ground and polished to a thickness of 30 to 50 μm [FIG. 1(c)], followed by formation of oxide film 30 of nearly 0.6 μm in thickness, for subsequent photo-lithography, over an outer surface of the substrate 22 as through thermal oxidation [FIG. 1(d)]. Small openings or windows 32 are formed photo-lithographically selectively in the oxide film 30 with the use of an isolation mask pattern [FIG. 1(e)], and the surface of the substrate 22 is anisotropically etched through the windows 32 into isolation grooves or moats 34 substantially vertically walled along the windows 32 so that island regions 36 are formed on both sides of each of the moats 34 [FIG. 1(f)]. An isolation oxide film 38 is then disposed in a thickness of about 2 μm and over both the islands and the moats [FIG. 1(g)]. Deposited over the oxide film 38 is a polycrystalline silicon layer 40 in a thickness of 40 to 80 μm [FIG. 1(h)], whereupon lapping is effected from toward the silicon layer 40 with the oxide film 38 being used as a stopper layer [FIG. 1(i)]. A dielectrically isolated substrate D2 is obtained by finally removing the oxide film 38 [FIGS. 1(j) and 2].

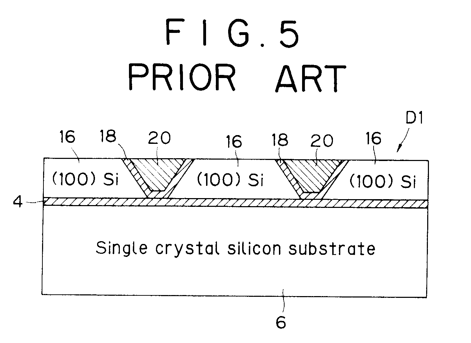

According to the process of the invention, the moats 34 vertically walled along the window 32 can be formed by anisotropic etching and with use of compensating mask patterns 44 with the result that the resulting islands 36 are made obtainable in substantially parallelogramtical posture and free from corner erosion. The (100) plane, single crystal silicon substrate 2 of the prior art has a greater width than its depth, say a square root of 2 as much. As is apparent from FIGS. 2 and 5, the structure D2 of the invention is incomparably larger in island than the structure D1 of the prior art.

The process of the invention incorporates the following features.

Mounted on the (110) plane of the bond substrate 22 is a mask pattern 42 of a parellologramatical shape with angles of 70.5° and 109.5° so as to form the window 32. As better shown in FIG. 3, a pair of sides 42a, 42a are positioned at a right angle with the direction vertical to one of the {111} planes located vertically to the bond substrate 22, the direction being illustrated as a [$\bar{1}$11] orientation or a

$$[1\bar{1}\bar{1}]$$

orientation. Another pair of sides 42b, 42b are positioned at a right angle with the direction vertical to another of the {111} planes located vertically to the bond substrate 22, the direction being illustrated as a [1$\bar{1}$1] orientation or a [$\bar{1}$1$\bar{1}$] orientation.

In anisotropic etching with an alkaline etchant, the (111) plane is etched at an extremely smaller etch rate than the (110) plane. Thus, the moat 34 vertically walled along the window 32 is formed in the (111) plane with the aid of the mask pattern 42. In addition to the {110} and {111} planes, third crystal planes {hkl} develop on the corners of the parallelogramatical island 36 intersecting with the vertical moat 34. The etch rate among these three planes is represented by the following equation

$$\{111\} \ll \{hkl\} < \{110\}$$

from which etching is formed to be performed relatively speedily. Excessive etching of the {hkl} planes renders the resultant island sharply erosive on the corners and hence inadequately small in the surface area. This problem is solved by the arrangement of the compensating pattern as represented in FIG. 3.

Anisotropic etching may preferably be effected with use of aqueous KOH, 50% by weight, at 80°C.

**Claims**

1. A dielectrically isolated substrate for use in integrated circuits, which comprises a single crystal silicon bond substrate and a single crystal silicon base substrate integrally bonded to the bond substrate, said bond substrate including a plurality of discrete, vertical moats and a plurality of parallelogramatical islands each positioned contiguous to each of said moats.

2. A dielectrically isolated substrate for use in integrated circuits, which comprises a single crystal silicon bond substrate having a (110) plane as a main crystal plane, and a single crystal silicon base substrate integrally bonded to said bond substrate, said bond substrate including a plurality of discrete, vertical moats and a plurality of parallelogramatical islands each positioned contiguous to each of said moats, each of said moats being formed by the use of a mask pattern of a parallelogramatical shape.

3. A process for producing a dielectrically isolated substrate for use in integrated circuits, which comprises the steps of:

(a) coating a single crystal silicon bond substrate with a dielectric film, bringing the bond substrate into intimate contact with a single crystal silicon base substrate and heat-treating the same into a composite structure;

(b) polishing the composite structure on a front surface of said bond substrate to a predetermined thickness;

(c) forming an oxide film for photo-lithograpy over the polished surface of the bond substrate;

(d) photo-lithographing the oxide film selectively with use of a mask pattern to thereby open a plurality of windows;

(e) etching the bond substrate through the windows to thereby form a plurality of moats terminating at the dielectric film and a plurality of islands each positioned contiguous to each of the moats;

(f) coating a dielectric isolation film onto the bond substrate;

(g) depositing a polycrystalline silicon layer in a thickness onto the dielectric isolation film;

(h) lapping the polycrystalline silicon layer until the surface of each of the islands is exposed; and

(i) subsequently removing the dielectric isolation film, wherein the bond substrate has a (110) plane as a main crystal plane and is subjected to anisotropic etching under alkaline conditions whereby each of the moats has a substantially vertical wall communicating with the dielectric film, and each of the islands has a parallelogramatical shape.

4. The process according to claim 3 wherein the bond substrate is anisotropically etched by the use of a mask pattern positioned thereon in a parallelogramatical form, the mask pattern having two opposite pairs of sides, one pair of sides exteding vertically to one group of the ⟨111⟩ orientation of the junction substrate, and another pair of sides being vertical to another group of the ⟨111⟩ orientation, the mask pattern further including a plurality of compensating patterns on its corners.

# F I G. 1

(a)

22
24
26

(b)

28
22
24
26

(c)

28
22
24
26

(d)

30
22
24
26

(e)

32          32    30
22
24
26

(f)

34    36    34
24
26

(g)

38    38    38
24
26

(h)

38    40
24
26

(i)

40    38    40
24
26

(j)

36    38    40    36    40    38    36    D2
24
26

# F I G . 2

# F I G . 3

# F I G . 4
# PRIOR ART

(a)

(b)

(c)

(d)

(e)

(f)

(g)

(h)

(i)

(j)

# F I G . 5
# PRIOR   ART